# EUROPEAN PATENT APPLICATION

(11) **EP 4 489 060 A1**
(43) Date of publication of application: **08.01.2025**
(21) Application number: 23184264.2
(22) Date of filing: 07.07.2023
(51) Int. Cl.: H01L 21/67

(54) **STAGE AND TOOL FOR HETEROGENEOUS INTEGRATION OF VARIABLY SIZED DIE**

(71) Applicant: ASML Netherlands B.V., 5500 AH Veldhoven (NL)
(72) Inventor: OTTENS, Joost, Jeroen, 5500 AH Veldhoven (NL); DE JAGER, Pieter, Willem, Herman, 5500 AH Veldhoven (NL); HUMPHREYS, Bedwyr, 5500 AH Veldhoven (NL); BENSCHOP, Jozef, Petrus, Henricus, 5500 AH Veldhoven (NL); VAN ZWET, Erwin, John, 5500 AH Veldhoven (NL); VAN RIEL, Martinus, Cornelius, Johannes, Maria, 5500 AH Veldhoven (NL)
(74) Representative: ASML Netherlands B.V.

(57) **Abstract**

A support structure for die comprising: an array of attachment connections configured to hold die actuators, each of the die actuators held by at least one attachment connection; and an array of controller connections configured to interface with die actuators to control movement of the die actuators, wherein the array of controller connections is interspersed in the array of attachment connections. And a system for die positioning comprising a first stage supporting an array of die actuators; a second stage supporting a plurality of acceptor target dies; and a measurement system functionally coupled to at least one of the first stage and the second stage and configured to: position at least one of the first stage and the second stage such that a position of the first donor die corresponds to a position of the first acceptor target die.

## Description

### TECHNICAL FIELD

The present disclosure relates generally to a stage and tool for heterogeneous integration.

### BACKGROUND

In manufacturing processes of integrated circuits (ICs), multiple finished or unfinished ICs (e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple die-where these specific portions which may be aligned in three-dimensional space to ensure functional connectivity. Alignment of these die, which may have multiple fabrication layers, different critical dimensions, different nodes, packaging, etc., with each other may require different techniques than use for lithography during fabrication. As the physical sizes of IC components continue to shrink, and their structures continue to become more complex, accuracy and throughput in integration become more important. For applications such as heterogeneous integration, it may be desirable to obtain both accurate and fast placement of die with respect to one another

In the context of semiconductor manufacture, improvements in die placement and alignment (e.g., improvements in heterogeneous integration) lead to improvements in IC manufacturing and integration abilities.

### SUMMARY

According to an embodiment, there is provided a support structure for die comprising: an array of attachment connections configured to hold die actuators, each of the die actuators held by at least one attachment connection; and an array of controller connections configured to interface with die actuators to control movement of the die actuators, wherein the array of controller connections is interspersed in the array of attachment connections.

In an embodiment, the support structure further comprises a plurality of die actuators, individual of the die actuators attached to the support structure via at least one of the attachment connections and individual of the die actuators connected to at least one of the controller connections.

According to another embodiment, a system is provided for die positioning comprising at least two support structures of any other embodiment.

According to another embodiment, there is provided a system for die positioning comprising: a first stage supporting an array of die actuators, wherein the die actuators are configured to actuate at least one of a plurality of donor dies; a second stage supporting a plurality of target dies; and a measurement system functionally coupled to at least one of the first stage and the second stage and configured to: obtain a relative position between a first donor die of the plurality of donor dies and a first acceptor target die of the plurality of target dies; position at least one of the first stage and the second stage such that a position of the first donor die corresponds to a position of the first target die; and activate a die actuator supporting the first donor die to place the first donor die on the first target die.

According to an embodiment, a die positioning tool configured to perform the method of any other embodiment is provided.

According to another embodiment, one or more non-transitory, machine-readable medium is provided having instructions thereon, the instructions when executed by a processor being configured to perform the method of any other embodiment.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Figures 1A-1D are schematic diagrams illustrating an exemplary die bonding method, according to an embodiment.
Figures 2A-2B are schematic diagrams illustrating an example apparatus for die bonding, according to an embodiment.
Figures 3A-3H are schematic diagrams illustrating a method of die placement, according to an embodiment.
Figures 4A-4C are schematic diagrams illustrating a support structure for die of various sizes, according to an embodiment.
Figures 5A-5B are schematic diagrams illustrating a method of die placement using an example support structure with two inputs, according to an embodiment.
Figures 6A-6B are schematic diagrams illustrating a method of die placement using an example support structure with four inputs, according to an embodiment.
Figure 7 is a flowchart which illustrates a method of die placement, according to an embodiment.
Figure 8 is a block diagram of an example computer system, according to an embodiment of the present disclosure.

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer"-that is a "die" may be produced by dicing or otherwise dividing a "wafer". The term "die" should be considered as interchangeable with the term chip, chiplet, or other terms for IC divisions. A patterning device (for example, a lithography device) can comprise, or can form, one or more patterns, which may correspond to one or more die. The patterns can be generated utilizing CAD (computer-aided design) programs, based on a pattern or design layout, this process often being referred to as EDA (electronic design automation). As used throughout this application "or", unless indicated otherwise, takes a non-exclusive meaning, e.g., encompassing both "and" and "or". "Each", "every", "all", "corresponding", "individual" and other relational terms encompass substantially "each", "every", "all", etc., including cases in which each, every, all, corresponding, individual, etc. may include relationship which are not one-to-one, or do not include every possible item. For example, every may exclude items, such as items determined to be defective during testing. Each may exclude items, such as edge items which are not used. All may exclude items, such as excess items. Corresponding may not require that items correspond in an exactly one to one manner. For example, a first item may correspond to two of a second item or vice versa. In some cases, individual may refer to multiple of an item, such as each item A has individual item B, where an item A may have two of an item B.

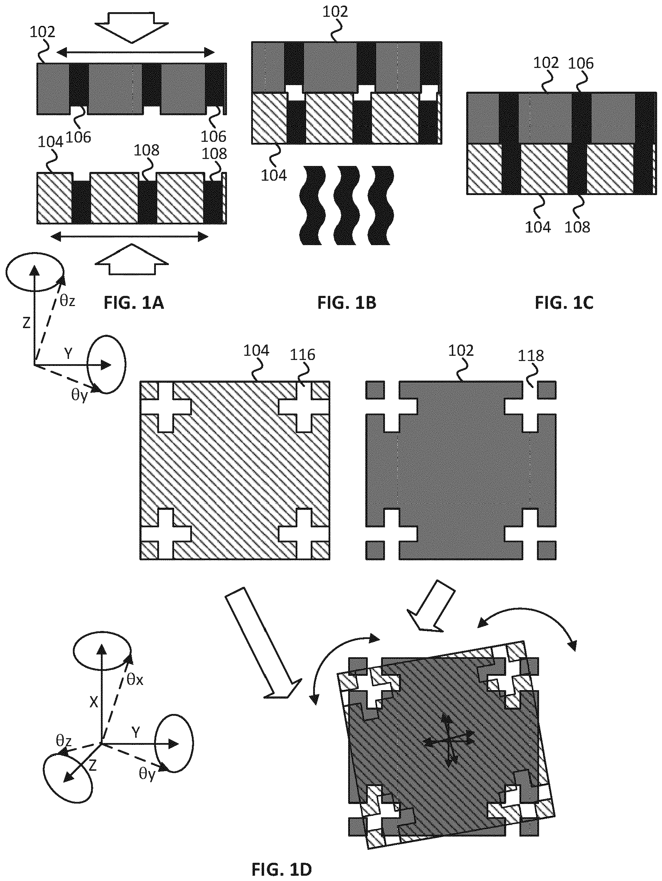

Reference is now made to Figures 1A-1D, which are schematic diagrams illustrating an exemplary die bonding method consistent with embodiments of the present disclosure. The exemplary die bonding method is depicted in relation to a reference set of axes, which are consistent through the schematic illustrations. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target locations.

As shown in Figures 1A-1D, the exemplary die bonding method may involve a donor die 102 and a target die 104. Herein, the term "donor" and the term "target" are used for ease of description. It should be understood that the term "donor" and the term "donor" are provided for reference and are relative and that elements described as corresponding to a "donor" can instead correspond to a "target" and vice versa. A target die may also or instead be called an acceptor die. The donor die 102 may have electrically active areas 106, such as on an alignment face of the donor die 102. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas) outside of the electrically active areas 106, such as on the alignment face of the donor die 102. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106.

As shown in Figure 1A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. The exemplary die bonding method may involve applying or maintaining pressure between the donor die 102 and the target die 104, such as while bonding (e.g., chemical bonding) occurs between the donor die 102 and the target die 104. The alignment may be complicated by the multiple layers of the donor die 102 or the multiple layers of the target die 104, which may be optically opaque. Figures 1A-1C depict a cross-sectional view of portions of the exemplary die bonding method.

As further shown in Figure 1A, the donor die 102 and the target die 104 may be brought together along the z-axis, while the position of the donor die 102 or the target die 104 may be adjusted in the x-y plane (e.g., perpendicular to the z-axis of approach), such as to improve alignment between the donor die 102 and the target die 104. As shown in Figure 1B, the donor die 102 and the target die 104 may be annealed after contact. Annealing may be or include heat annealing, electrical annealing, electrostatic processes, van der Waals processes, etc. As shown in Figure 1C, annealing may cause physical or chemical changes in the electrically active areas 106 of the donor die 102 or in the electrically active areas 108 of the target die 104 which may cause physical contact or electrical contact between the electrically active areas 106 in the electrically active areas 108. Annealing may therefore produce electrical connectivity between elements of the donor die 102 and the target die 104 (e.g., integration). This electrical connectivity may occur even if the electrically active areas 106 and the electrically active areas 108 differ-for example, have different recessed depths, are made up of different materials, have different dimensions, etc.

Figure 1D depicts a plan view of an example die bonding method according to this disclosure. As shown in Figure 1D, the donor die 102 and the target die 104 may have alignment marks along the x-y plane to facilitate alignment of the die as a whole. Alignment marks in the x-y plane of die (e.g., alignment marks 116 on the donor die 102 or alignment marks 118 on the target die 104) may reduce the area available for circuitry. Alignment marks may be additively or substractively fabricated, such as by etching or deposition in the z-direction. Alignment marks (such as alignment marks used for alignment of one or more fabrication layer during lithography) used during fabrication of wafers may be placed in waste areas, such as areas between chips, which may then be destroyed (e.g., removed) during dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method-for example, scribing and breaking, mechanical sawing, laser cutting, etc.-and may destroy (e.g., grind to powder or otherwise render inoperable for circuitry placement) a non-zero linewidth portion of the wafer volume when separating die. Alternatively, the electrically active areas 106 of the donor die 102 or the electrically active areas 108 of the target die 104 (not shown in Figure 1D) or other surface features (for example, metal contact pads) may function as reference marks for alignment (e.g., alignment marks) of the donor die 102 and the target die 104. The donor die 102 and the target die 104 may be aligned in three dimensions before or during contact between the donor die 102 and the target die 104. For example, the donor die 102 or the target die 104 may be positioned or adjusted in the x-y plane as the donor die 102 in the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the X axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes-e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

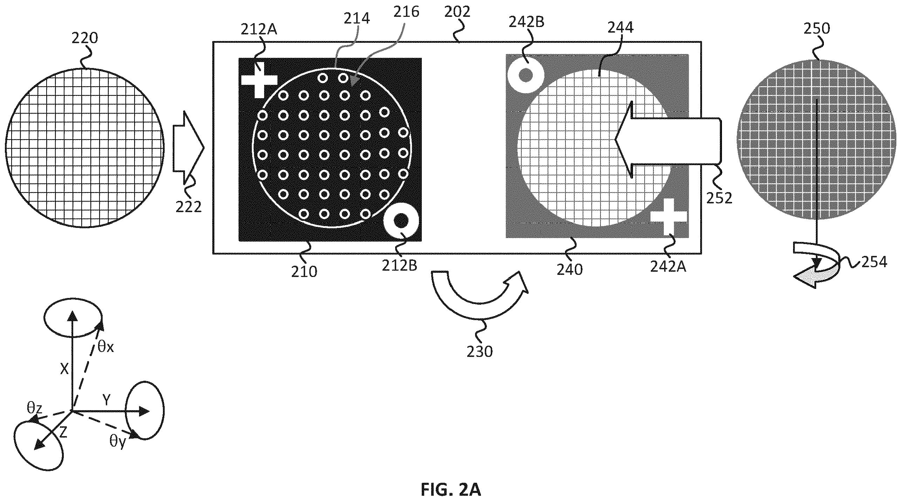

Figures 2A-2B are schematic diagrams illustrating an example apparatus for die bonding,. Figures 2A-2B are described with reference to "donor die" (and "donor wafer" containing multiple "donor die") and "target die" (and "target wafer" containing multiple "target die"), which are relative descriptors and donor die may instead be target die and vice versa. Figure 2A is a plane view of placement of donor die on the target die. A donor wafer 220 (and the target wafer 250) is depicted as circular, but may instead be any appropriate shape. The donor wafer 220 may be partially or fully diced into donor die. The donor wafer may be a "reconstructed wafer", in which donor die (or other disparate portions of the wafer) are arranged or supported to approximate their positions in the wafer from which they were diced. The donor wafer 220 may be supported, such as by a vacuum chuck, electrostatic chuck, etc., by either a tope side (e.g., fabrication face) or backside (e.g., bulk wafer face). The donor wafer 220 may have fabricated devices on multiple faces, such as through silicon vias (TSVs), contact pads, etc., such that both a top side and backside are fabrication faces.

The donor wafer 220 may be placed on a donor wafer chuck 210. The donor wafer chuck 210 may be located in a first position (e.g., a measurement position) on a frame 202. The donor wafer chuck 210 may contain (e.g., support) die actuators 216 (or "pushers"). The die actuators 216 may have a pitch (e.g., regular spacing) that corresponds to the pitch (or size) of the donor dies of the donor wafer 220. The die actuators 216 may have one or more adhesion surface, such that the donor dies are held by the die actuators 216. The die actuators 216 may have one or more controllable extension, such that the die actuators 216 may move the donor die in one or more directions, including in along one degree of freedom (e.g., along the Z axis), in up to three degrees of freedom (e.g., along the X, Y, and Z axes), and in up to six degrees of freedom (e.g., along the orthogonal axes and rotationally along the X, Y, and Z axes). The die actuators 216 may be controlled by one or more inputs (e.g., signal), including by electrical actuation, by vacuum actuation, by compressed air actuation, etc. The die actuators 216 may be any appropriate die actuators. The die actuators 216 may be supported by "feet" or other die actuator supports, which may interact with the donor wafer chuck 210 via an array 214 of connections (e.g., connections between the donor wafer chuck 210 and the die actuators 216).

The array 214 may contain connections that provide a means of adhesion for the die actuators 216, such as vacuum adhesion. The array 214 may contain connections that provide a means of actuation for the die actuators 216, such as a signal which may control movement of the die actuators 216 in one or more directions. The array 214 may contain as many connections as die actuators 216, more connections than die actuators 216 (including two times, three times, four times, etc. more connections than die actuators, etc. The array 214 may contain connections which are not attached to or otherwise do not correspond to die actuators 216. For example, each of the die actuators 216 may occupy four connections, which may be different types of connections, while only 10% of the connections are occupied by die actuators 216. The vacancy rate of the connections of the array 214 may be as much as 100% (e.g., in an example where die actuators 216 are not used) and as low as 0% (e.g., in an example where each connection is occupied by a die actuator 216). The die actuators 216 may be placed on the array 214 of connections (such as by a pick and place tool) in various configurations and may be engaged and disengaged with the connections of the array 214 and moved about the array 214. The array 214 may be operated by one or more control system, which may include processors, computer-readable instructions, etc., which may include a vacuum control system, an actuator control system, an electrical control system, a mechanical control system, etc.

The donor wafer chuck 210 may have a zero measurement point (or alignment point), such as identified by a cruciform zero measurement mark 212A and a round zero measurement mark 212B, which are provided as examples and where any appropriate zero measurement mark may be used. The zero measurement point may be used to place the donor wafer 220 on the donor wafer chuck 210, such as during movement of the wafer onto the chuck (for example, by insertion of the donor wafer along direction 222 by a wafer handler). The zero measurement point may be used to measure relative positions of the donor die of the donor wafer 220 once the donor dies are placed on the donor wafer chuck 210 (e.g., supported by the die actuators 216). The placement of the die actuators 216 may be measured, such as with up to nm precision, with respect to the zero measurement point. The placement of the donor die on the die actuators 216 may be measured, such as with up to nm precision, with respect to the zero measurement point. The placement of the donor die on the die actuators 216 (or of the die actuators 216 on the array 214) may be controlled with up to µm precision. The measurement of the position of the donor die after their placement may be obtained from any appropriate measurement system, such as optical microscopy, reflectometry, diffraction, etc. If the die actuators 216 operate in two or more degrees of freedom, positions of the donor die may be adjusted after placement on the die actuators 216.

Once the position of the donor die is measured, the donor wafer chuck 210 may be moved, such as about a central Z axis along the direction 230. The donor wafer chuck 210 may then occupy a second position on the frame 202 (e.g., a bonding position). A donor wafer chuck 240 is depicted at the second position on the frame 202, but may instead be the donor wafer chuck 210 after movement. The frame 202 may contain multiple position-for example, the frame 202 may be substantially rotationally symmetric containing a first position for placement of the donor wafer 220 on a donor wafer chuck, a second position for measurement of the position of donor die, a third position for placement of the donor die on the target die, and a fourth position for removal of the bonded die pairs from the donor wafer chuck. The donor wafer chuck 240 may be substantially identical to the donor wafer chuck 210, including cruciform zero measurement mark 242A and round zero measurement mark 242B, array and die actuators (not depicted in plane view), and donor wafer 244.

At the second position, a target wafer 250 may be placed parallel to the donor wafer 244, such as by a wafer handler or other appropriate device moving in a direction 252. The target wafer 250 may be rotated about an x-axis in the direction 254 such that a fabrication surface of the target wafer 250 faces the donor wafer 244. The target wafer 250 may be any appropriate target wafer, including a reconstructed wafer of target dies. The target dies of the target wafer 250 may be substantially the same size as the donor dies of the donor wafer 244. The target dies of the target wafer 250 may be substantially different sizes, in one or more dimensions, that the donor dies of the donor wafer 244. The target wafer 250 may be lowered onto the donor wafer 244. The donor dies of the donor wafer 244 may be placed in contact with the target dies of the target wafer 250, such as by operation of one or more die actuator supporting the donor dies and, optionally, one or more die actuator supporting the target dies. Contact between the donor dies and the target dies may be maintained during a bonding period (such as during travel of a chemical bonding front), during annealing, etc.

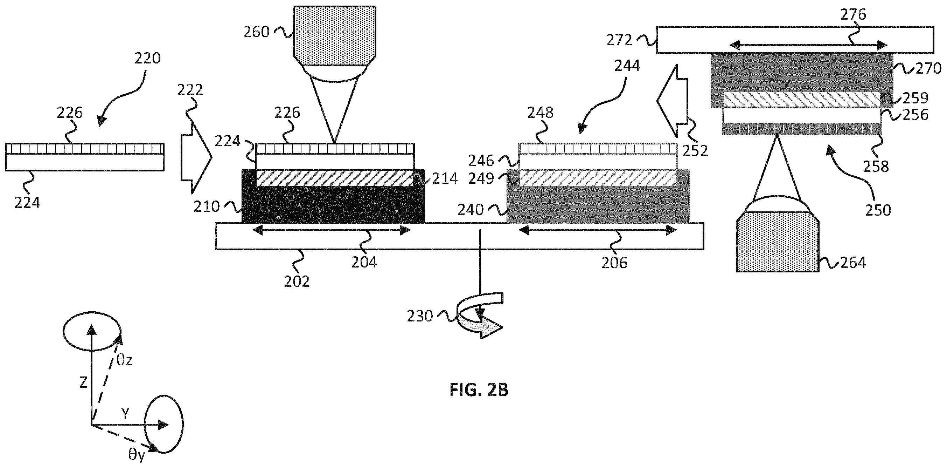

Figure 2B is a cross-sectional view of placement of donor die on the target die. The donor wafer 220 may contain a fabrication face 226 and a bulk wafer face 224, where the fabrication face 226 may contain one or more features which may be used for alignment between the donor die and the target die. The donor die may be placed on the donor wafer chuck 210, which may contain the array 214 of connections which support die actuators and the donor wafer 220. The array 214 may be recessed into the donor wafer chuck 210, protrude partially or fully from a face of the donor wafer chuck, etc. The array 214 may be considered together with any applied die actuators or separately from any applied die actuators. The donor wafer chuck 210 may be operable to move along two degrees of freedom (e.g., in the X-Y plane along a direction 204), along three degrees of freedom (e.g., along the X-Y plane and rotationally in the X-Y plane), or in other directions. Positions of the one or more features of the fabrication face 226 may be measured, such as optically, by one or more measurement systems 260. The measurement system 260 may measure the locations of the one or more features with respect to a zero measurement mark (as discussed in reference to Figure 2A). After the locations of the donor die are measured, the donor die chuck 210 may rotate to the position of the donor die chuck 240, such as along the direction 230. At the second position, the donor wafer 244 (which may be the donor wafer after translation) may be aligned with the target wafer 250.

At the second position, the donor wafer 244 is depicted as supported by the donor die chuck 240, which may move in various directions 206 in order to align the donor die of the donor wafer 244 with the target die of the target wafer 250. The donor wafer 244 may contain a fabrication face 248 and a bulk wafer face 246 (but may instead have multiple fabrication faces). The donor wafer may be supported by an array 249 of connections and die actuators, which may be substantially identical to the array 214 or which may be different from the array 214. For example, the placement of die actuators on the array 214 may be different from the placement of die actuators on the array 249, such as when die of different sizes make up the donor wafer 220 and the donor wafer 244.

The target wafer 250 may also have a fabrication face 258 and a bulk wafer face 256 (or multiple fabrication faces). The fabrication face 258 of the target wafer 250 may be rotated such that it faces the fabrication face 248 of the donor wafer 244. The target wafer 250 may be supported by a target wafer chuck 270, which may be supported by a support arm 272 or another wafer handling device. The target wafer chuck 270 may contain an array 259 and one or more die actuators. The target wafer chuck 270 may instead contain no die actuators or die actuators significantly different than the die actuators of the donor wafer chuck 210 or the donor wafer chuck 240. Positions of the target die (or of features of the target die) of the target wafer 250 may be measured, such as optically, by one or more measurement systems 264. The measurement system 264 may measure the locations of target die with respect to a zero measurement mark (as discussed in reference to Figure 2A), where the zero measurement mark may be located on the target wafer chuck 270 or the donor wafer chuck 240. In some embodiments, the measurement system 264 may measure positions of the target die from within the donor wafer chuck 240 or otherwise through the donor wafer 244.

The support arm 272 or another appropriate method may move the target wafer 250 such that the target wafer 250 corresponds (e.g., about a plane of symmetry) to the donor wafer 244, such as along direction 276. The movement of the donor wafer 244 (e.g., along the direction 206) and the target wafer 250 (e.g., along the direction 276) may occur based on a difference between the measured locations of a donor die and a corresponding target die. The donor wafer 244 and the target wafer 250 may be re-aligned for each successive pair of donor die and target die. The target wafer 250 and the donor wafer 244 may be brought into contact by movement along the Z-axis of either wafer or of individual die of either wafer.

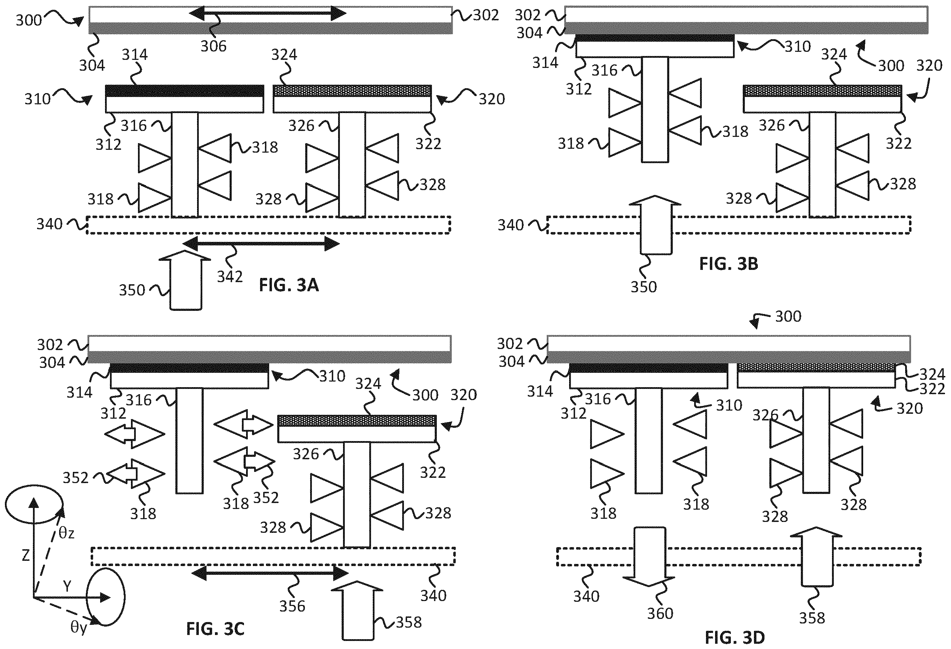

Figures 3A-3H are schematic diagrams illustrating a method of die placement. Figures 3A-3H are described with reference to "donor die" (and "donor wafer" containing multiple "donor die") and "target die" (and "target wafer" containing multiple "target die"), which are relative descriptors and donor die may instead be target die and vice versa. Figures 3A-3H are cross-sectional views of various steps of placement of donor die on target die. In some embodiments, the steps of Figures 3A-3H may be performed by the example apparatus of Figures 2A-2B. In some embodiments, multiple steps which are depicted as occurring substantially simultaneously in Figures 3A-3H may be performed sequentially. In some embodiments, multiple steps which are depicted as occurring sequentially in Figures 3A-3H may be performed substantially simultaneously. In some embodiments, steps may be performed in a different order.

Figure 3A is a cross-sectional view of donor dies 310 and 320 which are to be placed on target die 300. Although one target die (target die 300) is depicted, the donor dies 310 and 320 may be placed instead on separate target dies. In some embodiments, the donor dies 320 and 320 may be placed with respect to the target die 300 and with respect to each other, such as abutting, layered on top of one another, etc. Although the target die 300 is depicted as not supported by die actuators, in some embodiments the target die may also be supported by die actuators.

The donor die 310 has a fabrication face 314 and a bulk wafer face 312, while the donor die 320 has a fabrication face 324 and a bulk wafer face 322. The donor die 310 is supported by a die actuator 316, while the donor die 320 is supported by a die actuator 326. The die actuators 316 and 326 are depicted as rectangles for ease of depiction, and such as depiction should not be taken as limiting on the type or method of operation of the die actuators. For example, the die actuators 316 and 326 may be leaf-spring die actuators, piezo electric die actuators, steppers, etc. The die actuators 316 and 326 are supported by a support structure 340. The support structure 340 may include an array of connections (not depicted). Each die actuator 316 and 326 may have a die actuator foot (not depicted) which interacts with the array of connections or other support structure 340. The die actuators 316 and 326 may be vertical pushes-that is, may operate to adjust a position of the donor die 310 or the donor die 320 along the Z-direction. The die actuators 316 and 326 may also be controlled along other directions, such as along the X and Y plane. The die actuator 316 may be controlled in the X-Y plane by guides 318. The die actuator 326 may be controlled in the X-Y plane by guides 328. The guides 318 and 328 are depicted as triangles, where their support structure is not depicted. The guides 318 and 328 may be any appropriate guides, such as guide rails, structs, clamps, etc.

The donor dies 310 and 320 may be moved in the X-Y plane by movement of the support structure 340, such as in a direction 342. In some embodiments, the target die 300 may also (or instead) be moved in the X-Y plane by movement of a support structure (not depicted), such as in the direction 306. In order to align the donor die 310 with the target die 300, the support structure 340 may be moved, such as based on a measured position of the donor die 310, to align the donor die 310 with the target die 300, which may be additionally based on a measured position of the donor die 310. The movement of the support structure 340 (or of a support structure of the target die) may be controlled, such as by microsteppers, with µm precision. If the die actuators operate in additional degrees of freedom (e.g., in directions other than along the Z-axis), the die actuators may also be used to align a given donor die with a given target die.

Once the donor die 310 is aligned with the target die 300, the donor die 310 may be moved (e.g., along a direction 350) into contact with the target die 300. The target die 300 may be moved by the die actuator 316. The die actuator 316 may be actuated by receipt of a control signal, which may be an electrical signal, a compressed air signal, a vacuum signal, etc., such as through the array or the support structure 340. In some embodiments, multiple donor die may be brough into contact at once. For example, if both the donor die 310 and the donor die 320 were aligned with their corresponding positions on the target die 300 for the same position of the support structure 340, the donor die 310 and the donor die 320 may be placed substantially simultaneously. "Aligned" and grammatical variations thereof herein includes alignment to within a tolerance threshold, and does not required atomic alignment. Alignment thresholds may depend on die size, feature size, die type, etc.

Figure 3B is a cross-sectional view of placement of the donor die 310 on the target die 300. The die actuator 316 may remain in contact with the support structure 340, while the donor die 310 held in contact with the target die 300. The die actuator 316 may separate from the support structure 340, while the donor die 310 is held in contact with the target die 300. For example, the die actuator 316 may be held in place by the guides 318, which may be connected to the support structure 340, a foot of the die actuator, etc. Examples of die actuator geometry are provided in later figures. The die actuator 316 may continue to supply pressure to the donor die 310 after the donor die 310 has contacted the target die 300. For example, the donor die 310 may be held in contact with the target die 300 during a bonding time period, which may be a time period calculated to allow a bonding front (e.g., for chemical bonds) to travel about a percentage of the surface of the fabrication face 314 of the donor die 310. The donor die 310 may be held in contact with constant pressure, ramping pressure, held with against the target die 300 substantially no pressure, etc.

Figure 3C is a cross-sectional view of alignment of the donor die 320 with the target die 300. After the donor die 310 is placed on the target die 300, the guides 318 may be removed from the die actuator 316. The guides 318 may, for example, be removed in the direction 352 in a radial direction outward from the die actuator 316 in the X-Y plane. The die actuator 316 may continue to hold the donor die 310 against the target die 300, with or without application of substantial pressure. Once the donor die 310 is no longer restricted in movement (e.g., by the guides 318) in the X-Y plane, the support structure 340 (or alternatively or in addition a support structure of the target die 300) may move to position the donor die 320 in alignment with the target die 300, such as along a direction 356. Once the donor die 320 is aligned with the target die 300, the die actuator 326 may move to bring the donor die 320 on the target die 300, such as in a direction 358. Alignment may be performed based on previous measurements (e.g., of positions of the donor die 310 and 320 with respect to a zero measurement mark) or based on new measurements.

Figure 3D is a cross-sectional view of placement of the donor die 320 on the target die 300. The die actuator 326 may place the donor die 320 on the target die 300, such as by movement in the direction 358. The die actuator 326 may remain in contact with the support structure 340, while the donor die 320 is held in contact with the target die 300. The die actuator 326 may be any appropriate die actuator, such as those previously described in relation to die actuator 316 and Figure 3B. The die actuator 326 may continue to hold or supply pressure to the donor die 320 as previously described in relation to the die actuator 316. The donor die 320 may be held in contact with the target die 300 during a bonding time period.

Once the bonding time period for the donor die 310 has expired, the die actuator 316 may be removed from the donor die 310. The donor die 310 may be held to the die actuator, such as by vacuum actuation, electrostatic forces, etc. The die actuator 316 may be removed from the donor die (e.g., retracted) with or without application of repulsion between the donor die 310 and the die actuator 316. The die actuator 316 may be moved in the direction 360 (e.g., back toward the support structure 340).

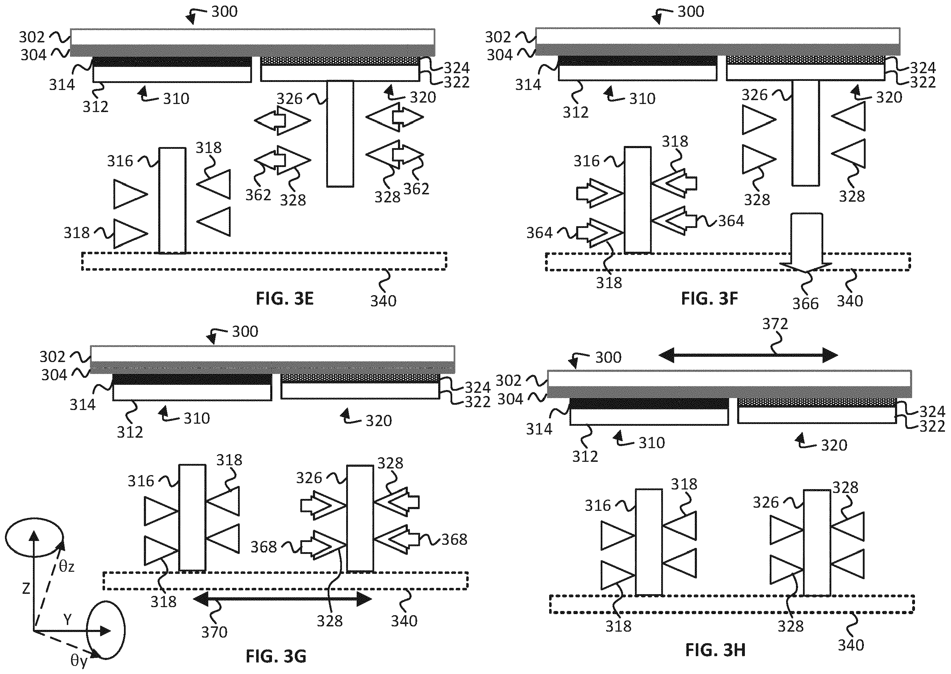

Figure 3E is a cross-sectional view of removal of the guides 328 from the die actuator 316 of the donor die 320. The removal of the guides 328 from the die actuator 316 may allow alignment of additional donor dies with the target die 300 (e.g., as previously described for the alignment of the donor die 320 with the target die 300 after the placement of the donor die 310 on the target die 300). The guides 328 may be removed in the direction 362 in a radial direction outward from the die actuator 326 in the X-Y plane, or by any other appropriate manner. The die actuator 326 may continue to hold the donor die 320 against the target die 300, with or without application of substantial pressure. Once the donor die 320 is no longer restricted in movement (e.g., by the guides 328) in the X-Y plane, the support structure 340 (or alternatively or in addition a support structure of the target die 300) may move to position another donor die in alignment with the target die 300 or perform another operation.

Figure 3F is a cross-sectional view of removal of the die actuator 326 from the donor die 320. Once a bonding time period for the donor die 320 has expired, the die actuator 326 may be removed from the donor die 320. The donor die 320 may be held to the die actuator, such as by vacuum actuation, electrostatic forces, etc. The die actuator 326 may be removed from the donor die (e.g., retracted) with or without application of repulsion between the donor die 320 and the die actuator 326. The die actuator 326 may be moved in the direction 366 (e.g., back toward the support structure 340).

Once the die actuator 316 is removed from the donor die 310 and returned to an original position (e.g., the position of the die actuator 316 as depicted in Figure 3A), the guides 318 may be re-engaged with the die actuator 316, such as by movement in a direction 364 radially toward the die actuator 316. The guides 318 may also be reattached to the die actuator 316 during the process of removing the die actuator 316 from the donor die 310.

Figure 3G is a cross-sectional view of re-engagement of the guides 328 with the die actuator 326. Once the die actuator 326 is removed from the donor die 320 and returned to an original position (e.g., the position of the die actuator 326 as depicted in Figure 3A), the guides 328 may be re-engaged with the die actuator 326, such as by movement in a direction 368 radially toward the die actuator 326. The guides 328 may also be reattached to the die actuator 326 during the process of removing the die actuator 326 from the donor die 320.

Once the die actuators 316 and 326 are returned to their original (or "neutral") position, the support structure 340 may be moved, such as in a direction 370, to apply additional donor dies to target dies, to receive additional donor dies, etc.

Figure 3H is a cross-sectional view of die actuators 316 and 326 prepared to receive additional donor die. Once all the donor dies have been placed on the target die, the target die may be removed, such as by a wafer handler along a direction 372. The removal of the bonded die (e.g., the donor die 310 and 320 bonded to the target die 300) may allow for additional donor die (and target die) to be placed on the die actuators 316 and 326 and for additional donor die and target die to be bonded. The die actuators 316 and 326 may be re-arranged between application of donor die, such as by use of a pick and place tool. The die actuators 316 and 326 may be adjusted to correspond to a pitch of the donor die (and target die) to be used in a given die to die bonding.

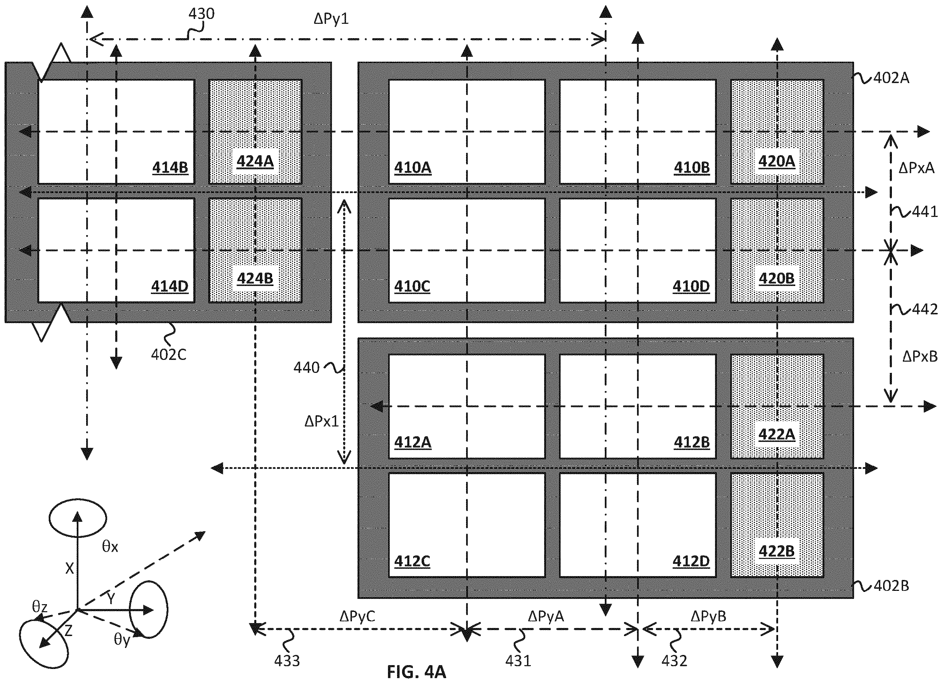

Figures 4A-4C are schematic diagrams illustrating a support structure for dies of various sizes. Figures 4A-4C are described with reference to "donor die" (and "donor wafer" containing multiple "donor die") and "target die" (and "target wafer" containing multiple "target die"), which are relative descriptors and donor die may instead be target die and vice versa. Figure 4A is a plane view of an example heterogeneous die bonding. In Figure 4A, bonding is depicted between target die 402A, 402B, and 402C, and various donor die. The target die 402A is bonded to donor die 410A-410D and 420A and 420B. The target die 402B is bonded to donor die 412A-412D and 422A and 422B. The target die 403C, which is only partially depicted, is bonded to at least donor die 414B, 414D, 424A, and 424B. Die to die bonding may be improved (e.g., in speed, accuracy, precision) by use of regular arrangements of donor and target die. For example, the apparatus of Figures 2A-2B may bond reconstructed donor wafers, made up of donor dies, to reconstructed target wafers, made up of target dies. Donor die and target die may be placed in regular arrangements, such that the donor die and target die have various pitches. For example, the target dies 402A-402C have a pitch 430 in the X-direction and a pitch 440 in the Y-direction. The donor die 410A-D, 412A-D, 414B and 414D have a first pitch 441 in the X-direction (corresponding to donor die on the same target wafer) and a second pitch 442 in the X-direction (corresponding to a separation in donor die of different target wafers). The donor die 420A-B, 422A-B, and 424A-D are also depicted with pitches 441 and 442 in the X-direction. The donor die 410A-D, 412A-D, 414B, 414D, 420A-B, 422A-B, and 424A-D have a first pitch 431 in the Y-direction (corresponding to separation between substantially identical donor die) and a second pitch 432 in the Y-direction (corresponding to a separation between different types of donor die) and a third pitch 433 in the Y-direction (corresponding to a separation in donor die of different target wafers).

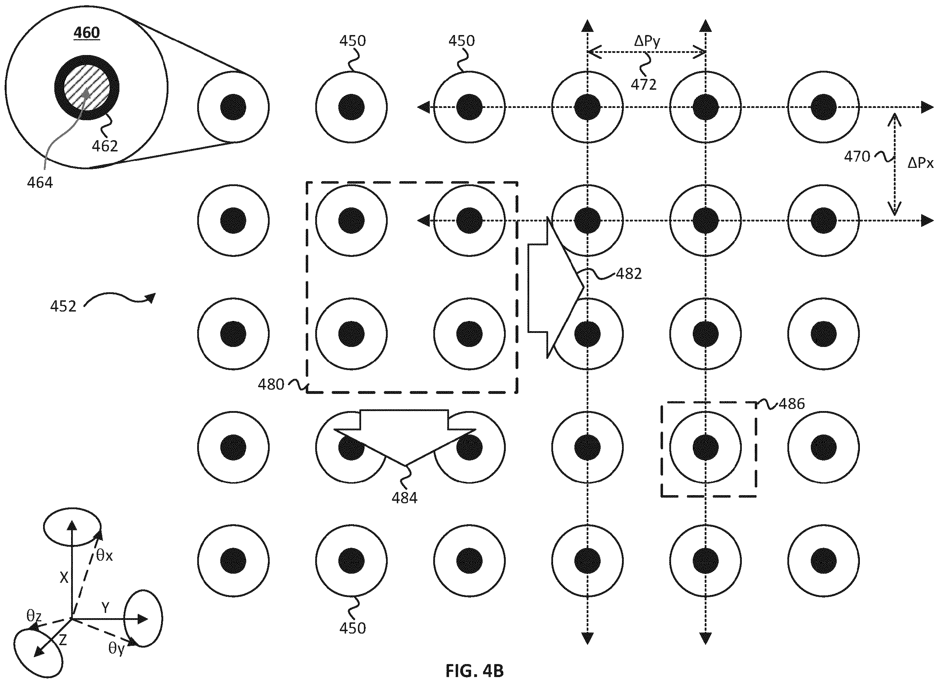

Figure 4B is a plan view of an example array 452 of connections to support donor die, such as for the example heterogeneous die bonding depicted in Figure 4A. The array 452 contains a plurality of attachment connections 450 which may hold die actuators for donor dies. The attachment connections 450 may contain vacuum orifices. The attachment connections 450 may be any appropriate attachment connection, such as pads for electrostatic attractions, etc. The attachment connections 450 may contain an attachment foot 460, which may secure a means of attachment (such as a vacuum source line) to the array 452. The attachment connections 450 may contain a vacuum line 462, or other supply line for a control or attachment signal. The vacuum line 462 may be a flexible tubing line, for example. The attachment connections 450 may define an orifice 464, through which an attractive force (e.g., vacuum force) may be supplied.

The attachment connections 450 may have a pitch 470 in the X-direction and a pitch 472 in the Y-direction. The pitches of the attachment connections 450 may be smaller than a minimum pitch of the donor die and target die. This may allow for the attachment connections 450 to support die actuators and die at the minimum pitch desired for a given die bonding. The attachment connections 450 are depicted in a square array but may be provided in any appropriate arrangement, including a close-packing arrangement, a radial array, a rectangular array, etc.

Each attachment connection 450 may operate to attach a die actuator to the array 452. Each die actuator placed on the array 452 may be attached to the array by one or more attachment connection 450. Some of the attachment connections 450 may not be attached to any die actuator-the placement of the die actuators on the array 452 may be dictated by the arrangement of the donor die for placement on the target die for any given die bonding. The die actuator may be attached to the array 452 by feet of the die actuator, where die actuator "feet" refers to any appropriate arrangement of a base of a die actuator. A dashed rectangle 480 represents an example die actuator foot placement on the array 452, where the die actuator may be moved about the array 452, including in directions 482 and 484 to attached at other of the attachment connections 450. The die actuators may be placed on the array 452 and held in place by gravity in addition to any applied attractive force. The attachment connections 450 may shave an attractive force, such as a vacuum supply source. In some embodiments, the attachment connections 450 may be individually activate.

A foot of the die actuator may occupy one or more attachment connections-a dashed rectangle 486 represents a die actuator foot which occupies one attachment connection. The foot of the die actuator may be configured to attach to the attachment connection 450 in a specific region. For example, the die actuator foot may have a flat surface suitable for vacuum attachment along the outside of the foot.

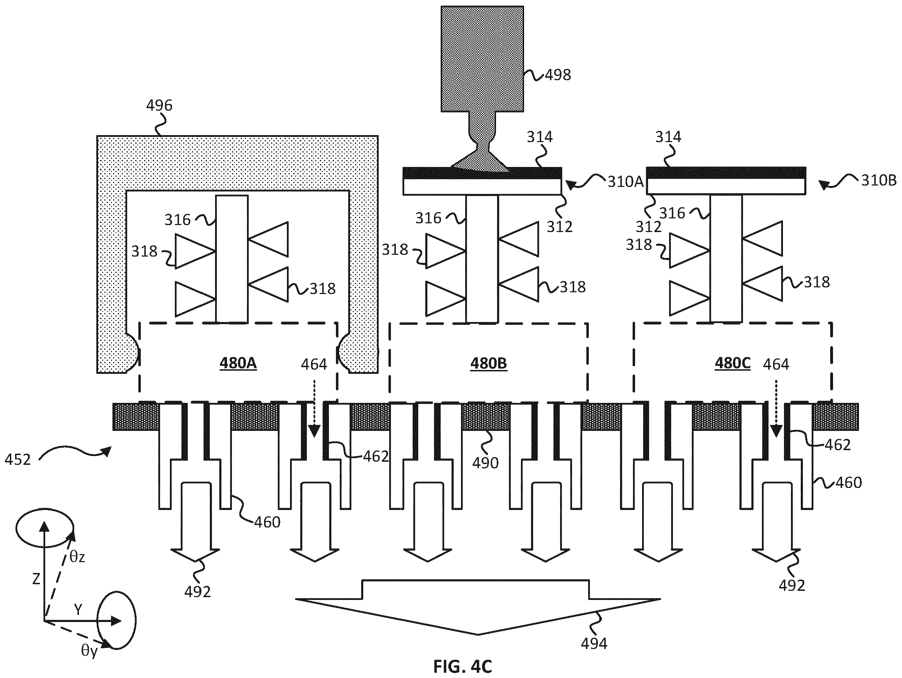

Figure 4C is a cross-sectional view of the example array 452 of connections to support donor die of Figure 4B, shown with example die actuators 316. The array 452 contains attachment connections, which contain the attachment foot 460, a vacuum line 462 or other supply line and an orifice 464. The attachment connections may be defined within an array support 490. The array support 490 may be substantially planar. The attachment feet 460 and orifices 464 may be substantially coplanar with the array support 490. In some embodiments, the attachment feet 460 and the orifices 464 may be recessed with respect to the array support 490 or vice versa. The orifices 464 may be supplied with vacuum force 492, which comes from a common vacuum supply 494. The orifices 464 may instead supply another force, such as an electrostatic attractive force, in which case the orifices may instead be contact pads.

The array 452 is depicted as supporting three die actuators 316, but may instead support fewer die actuators. The array 452 may have orifices 464 which operating to hold die actuators 316, such as orifices for which the vacuum force 492 is applied to frees pace, which may be atmosphere, inert gas, etc. The common vacuum supply 494 may be supplied in sufficient force that application of at least some of the vacuum force 492 to free space does not prevent the vacuum force 492 from attaching die actuators 316. For example, the vacuum force 492 may be substantially equal to a vacuum level less than or equal to -0.3 bar with a flow of less than 20 normal liters per minute (Nl/min).

The array 452 may have die actuators 316 and donor die (e.g., donor die 310A-B) placed upon it. The die actuators 316 may be supported by a die actuator foot 480A, 480B, 480C. The die actuator feet 480A-480C may be any appropriate support for the die actuators 316. The die actuators 316 may be placed on the array 452 by use of a pick and place tool, including by use of a pick and place tool which may interact with a die actuator holder 496. The die actuator holder 496 may interact with the die actuator 316, including through interaction with the die actuator foot 480A, and allow the pick and place tool to move the die actuator 316. Once the die actuator 316 is attached to the array 452, whether by gravity or an attachment connection, the die actuator holder 496 may be removed. The die actuator holder 496 may also be used to move the die actuator 316 about the array 452.

Once the die actuator is placed on the array 452, the donor die 301A may be placed on the die actuator 316. The donor die 310A may be placed on the die actuator 316 by a pick and place tool 498 or any other appropriate wafer handling method. Once the donor die 310B is secured to the die actuator 316, including by active (e.g., electrostatic) or passive (e.g., van der Walls) forces, the donor die 301B may by aligned with a target die, such as by the method of die placement described in reference to Figures 3A-3H or any other appropriate method.

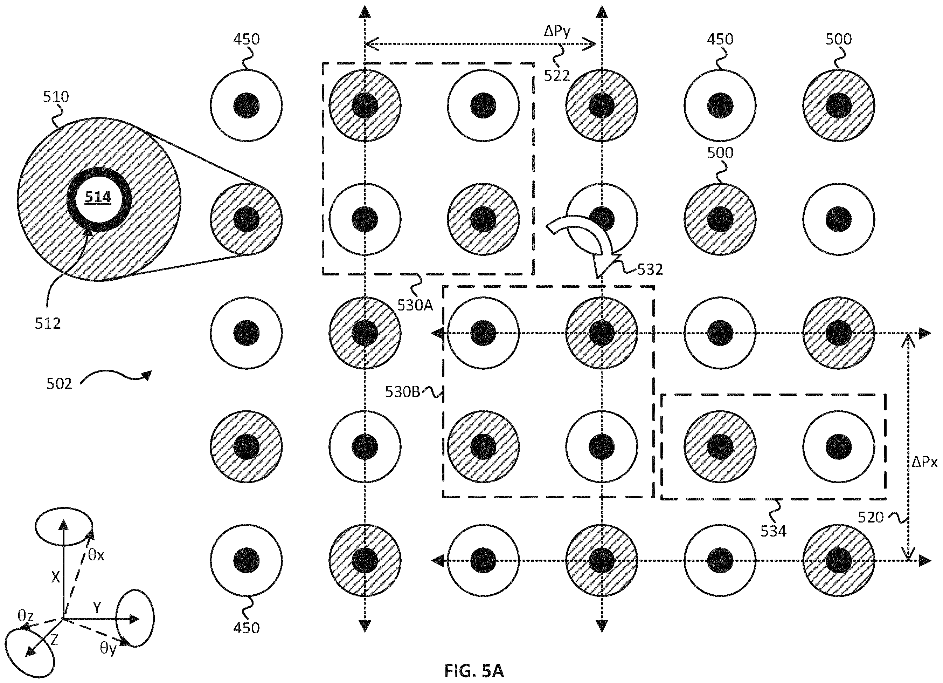

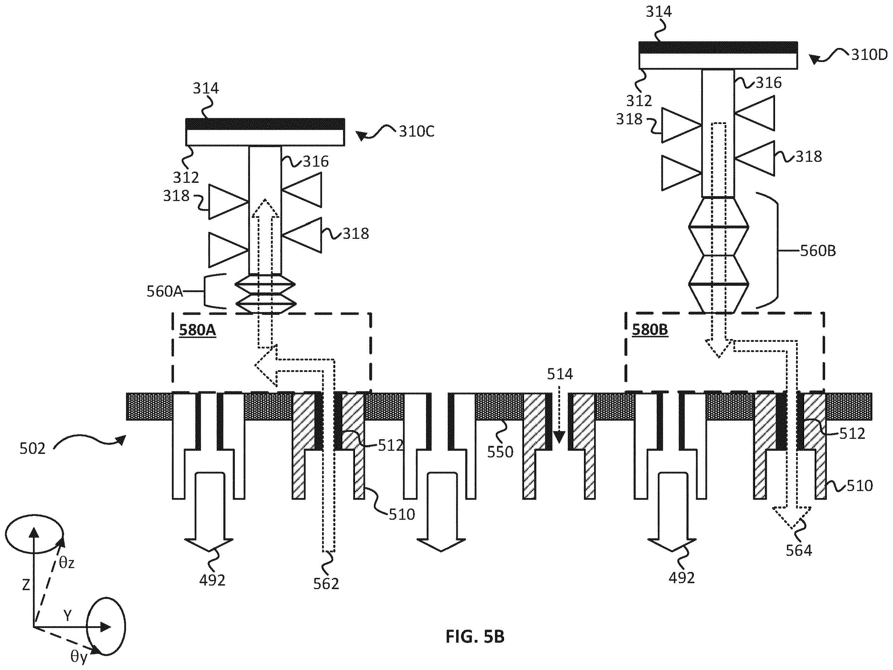

Figures 5A-5B are schematic diagrams illustrating a method of die placement using an example support structure with two inputs. Figures 5A-5B are described with reference to "donor die", which is a relative descriptor and donor die may instead be target die. Figure 5B is a plan view of an example array 502 of connections to support donor die, such as for the example heterogeneous die bonding depicted in Figure 4A. The array 502 contains a plurality of attachment connections 450, which may be any appropriate attachment connections, such as those previously described in reference to Figures 4B-4C. The array 502 contains a plurality of controller connections 500, which may control die actuators holding donor dies.

The controller connections 500 may contain orifices, which may provide vacuum, compressed air, or other through signals. The controller connections 500 may be any appropriate controller connection, such as pads for electrostatic attractions. The controller connections 500 may contain an attachment foot 510, which may secure a means of attachment (such as a vacuum source line, voltage source line, etc.) to the array 502. The controller connections 500 may contain a vacuum line 512, or other supply line for a control signal. The vacuum line 512 may be a flexible tubing line, for example. The controller connections 500 may define an orifice 514, through which an attractive force (e.g., vacuum force) may be supplied. The controller connections 500 may be individually controller, such as by application of individual signals to the controller connections 500. The controller connections 500 may be batch controlled, such as by application of column and row signals to the controller connections 500.

Each controller connection 500 may operate to control actuation of a die actuator on the array 502. Each die actuator placed on the array 502 may be attached to the array by one or more attachment connection 450 and controlled by one or more controller connection 500. Some of the controller connections 500 may not be attached to any die actuator. The die actuators may be attached to the array 502 by feet of the die actuator and the controller connections 500 may supply one or more control signal to the die actuator feet. A foot of the die actuator may occupy one or more attachment connection and controller connections-a dashed rectangle 534 represents a die actuator foot which occupies one attachment connection 450 and one controller connection 500. The foot of the die actuator may be configured to attach to the attachment connection 450 in a first specific region and the controller connection 500 in a second specific region. For example, the die actuator foot may have a flat surface suitable for vacuum attachment along the outside of the foot and a recessed surface suitable for compressed air supply in the interior of the foot.

A dashed rectangle 530A represents an example die actuator foot placement on the array 502, where the die actuator may be moved about the array 502. A dashed rectangle 530B represents translation (e.g., in a direction 532) of the example die actuator foot placement of the dashed rectangle 530A to another location on the array 502. The feet of the die actuators may have specific regions to which the controller connections 500 (and the attachment connections 450) correspond (e.g., connect). The specific regions of the feet of the die actuators may dictate positions of the array 502 on which the die actuators may be placed. By rotating the die actuators (or their feet), a single configuration of the die actuator foot may be used for placement on any four of the connections (e.g., attachment connections 450 and controller connections 500).

The attachment connections 450 and the controller connections 500 may have a pitch 520 in the X-direction and a pitch 522 in the Y-direction. The pitches of the array 502 may be smaller than a minimum pitch of the donor die and target die. This may allow for the attachment connections 450 and the controller connections 500 to support and control die actuators and die at the minimum pitch desired for a given die bonding. The attachment connections 450 and the controller connections 500 are depicted in a square array but may be provided in any appropriate arrangement, including a close-packing arrangement, a radial array, a rectangular array, etc. The attachment connections 450 and the controller connections 500 may occur in interspersed (e.g., interwoven) arrays, which may be of different pitches. For example, an attachment connection 450 may be located at vertices of a square array while controller connections 500 (including controller connections of sizes substantially different from those of the attachment connection 450) may surround the attachment connection 450 in a 4-fold radially symmetric arrangement or other appropriate arrangement.

Figure 5B is a cross-sectional view of the example array 502 of connections to support and control donor die of Figure 5A, shown with example die actuators 316. The array 502 contains controller connections, which contain the controller foot 510, a vacuum line 512 or other supply line and an orifice 514. The array 502 also contains attachment connections, as previously described in reference to Figure 4C. The attachment connections and controller connections may be defined within an array support 550. The array support 550 may be substantially planar. The attachment feet 510 and orifices 514 may be substantially coplanar to the array support 550. In some embodiments, the attachment feet 510 and the orifices 514 may be recessed with respect to the array support 550 or vice versa. The orifices 514 may be supplied with a variable compressed air signal. The orifices 514 may instead supply another force, such as an electrostatic attractive force, in which case the orifices may instead be contact pads.

The array 502 is depicted as supporting two die actuators 316, but may instead support more or fewer die actuators. The array 502 may have orifices 514 which operating to control die actuators 316, such as orifices 514 which supply compressed air to extend the die actuator 316 and orifices which supply a vacuum force to retract the die actuator 316. The orifices 514 may be individually controlled, such as by supplying an individual control signal to each of the orifices 514. The orifices 514 which do not correspond to (e.g., are not controlling) die actuators 316 may be turned off or otherwise not supplied with a control signal.

The array 502 may have die actuators 316 and donor die (e.g. donor die 310C-D) placed upon it. The die actuators 316 may be supported by a die actuator foot 580A and 580B. The die actuator feet 580A-B may be any appropriate support for the die actuators 316. The die actuators are depicted as containing an expandable bellows 560A and 560B for actuation in the Z-direction. The expansion and contraction of the expandable bellows 560A and 560B may be controller by signals supplied through the controller connections. The expandable bellows 560A and 560B are provided as an example, but the actuation of the die actuators 316 may occur via any appropriate method or structure.

A "push" signal 562 may be supplied via a controller connection. The push signal 562 may operate to cause the die actuator 316 to extend to place the donor die 310C on the target die. The push signal 562 may cause an expansion of the expandable bellows 560A.

A "retract" signal 564 may be supplied via a controller connection. The retract signal may operate to cause the die actuator 316 to retract from holding the donor die 310D on the target die. The retract signal 564 may cause a compression of the expandable bellows 560B.

In some embodiments, a "hold" signal may be supplied via a controller connection. The hold signal may operate to cause the die actuator 316 to hold a donor die on the target die, with or without substantial pressure.

In some embodiments, the retract signal may be absence of a push signal, or vice versa, such as for spring loaded die actuators. In some embodiments, a push signal may automatically include a hold signal or period or other ramping of pressure between a donor die and target die, such as for dash pot based die actuators.

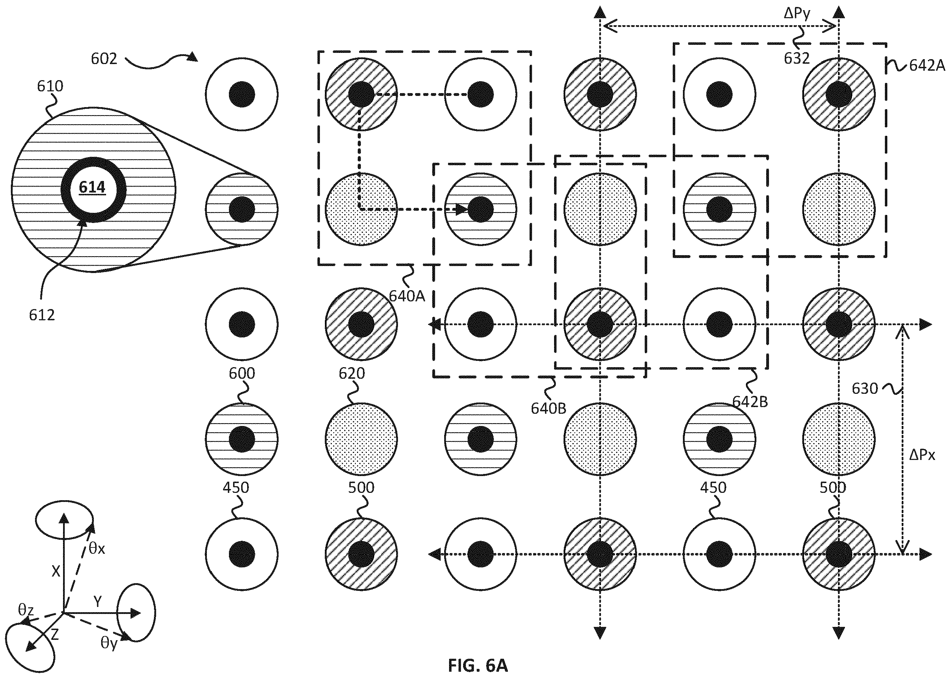

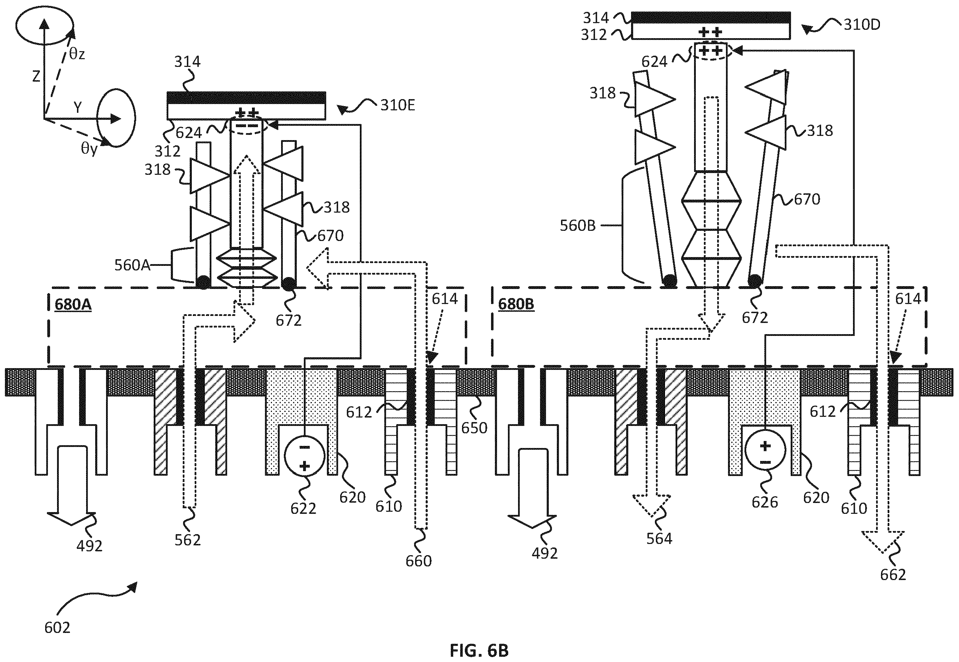

Figures 6A-6B are schematic diagrams illustrating a method of die placement using an example support structure with four inputs. Figures 6A-6B are described with reference to "donor die", which is a relative descriptor and donor die may instead be target die. Figure 6B is a plan view of an example array 602 of connections to support donor die, such as for the example heterogeneous die bonding depicted in Figure 4A. The array 602 contains a plurality of attachment connections 450, which may be any appropriate attachment connections, such as those previously described in reference to Figures 4B-4C and Figures 5A-5B. The array 602 contains a plurality of controller connections 500, which may be any appropriate controller connections, such as those previously described in reference to Figures 5A-5B. The array 502 contains a plurality of additional controller connections 600 and 620. The controller connections 600 and 620 may be any appropriate controller connections, and may be substantially the same as or different from the controller connections 500 and each other. The controller connections 500, 600, and 620 may each control a different aspect of actuation (e.g., movement) of the die actuators 316.

The controller connections 600 may contain orifices, which may provide vacuum, compressed air, or other through signals. The controller connections 600 may be any appropriate controller connection, such as pads for electrostatic attractions. The controller connections 600 may contain a controller foot 610, which may secure a means of attachment (such as a vacuum source line, voltage source line, etc.) to the array 602. The controller connections 600 may contain a vacuum line 612, or other supply line for a control signal. The vacuum line 612 may be a flexible tubing line, for example. The controller connections 600 may define an orifice 614, through which an attractive force (e.g., vacuum force) may be supplied. The controller connections 600 may be individually controller, such as by application of individual signals to the controller connections 600. The controller connections 600 may be batch controlled, such as by application of column and row signals to the controller connections 600. The controller connections 620 may contain pads (e.g., voltage supply pads) for electrostatic control. The controller connection may contain a controller foot, which may contain a pad as the exposed surface. The controller connection may be connected to one or more electrical signal supply lines.

Each controller connection 600 and 620 may operate to control one or more actuations of a die actuator on the array 602. Each die actuator placed on the array 602 may be attached to the array by one or more attachment connection 450 and controlled by one or more controller connection 500, 600, and 620. Some of the controller connections 600 and 620 may not be attached to any die actuator. The die actuators may be attached to the array 602 by feet of the die actuator and the controller connections 500, 600 and 620 may supply one or more control signal to the die actuator feet. A foot of the die actuator may occupy one or more attachment connection and controller connections-a dashed rectangle 640A represents a die actuator foot which occupies one attachment connection 450, one controller connection 500, one controller connection 600, and one controller connection 620. The foot of the die actuator may be configured to attach to the attachment connection 450 in a first specific region, the controller connection 500 in a second specific region, the controller connection 600 in a third specific region, and the controller connection 620 in a fourth specific region. For example, the die actuator foot may have a flat surface suitable for vacuum attachment in a first radial quadrant, a recessed surface suitable for compressed air supply a second radial quadrant, an electric pad suitable for reception of an electrical signal in a third radial quadrant, and an orifice suitable for reception of vacuum supply in a fourth radial quadrant.

A dashed rectangle 640A represents an example die actuator foot placement on the array 602, where the die actuator may be moved about the array 502. A dashed rectangle 640B represents translation (e.g., a rotation) of the example die actuator foot placement of the dashed rectangle 640A to another location on the array 602. A dashed rectangle 642A represents an example die actuator foot placement on the array 602, where the die actuator foot of the dashed rectangle 642A is a mirror image of the die actuator foot of the dashed rectangle 640A. A dashed rectangle 642B represents translation (e.g., a rotation) of the example die actuator foot placement of the dashed rectangle 642A to another location on the array 602. By including rotation die actuators (or die actuator feet), two different die actuator feet can be used such that a die actuator foot can be placed anywhere on the array 602.

The attachment connections 450 and the controller connections 500, 600, and 620 may have a pitch 630 in the X-direction and a pitch 632 in the Y-direction. The pitches of the array 602 may be smaller than a minimum pitch of the donor die and target die. This may allow for the attachment connections 450 and the controller connections 500, 600, and 620 to support and control die actuators and die at the minimum pitch desired for a given die bonding. The attachment connections 450 and the controller connections 500, 600, and 620 are depicted in a square array but may be provided in any appropriate arrangement, including a close-packing arrangement, a radial array, a rectangular array, etc. The attachment connections 450 and the controller connections 500, 600, and 620 may occur in interspersed (e.g., interwoven) arrays, which may be of different pitches. For example, an attachment connection 450 may be located at vertices of a square array while controller connections 500, 600, and 620 (including controller connections of sizes substantially different from those of the attachment connection 450) may surround the attachment connection 450 in a 3-fold radially symmetric arrangement or other appropriate arrangement.

Figure 6B is a cross-sectional view of the example array 602 of connections to support and control donor die of Figure 6A, shown with example die actuators 316. The array 602 contains controller connections, which contain the controller foot 610, a vacuum line 612 or other supply line and an orifice 614 (e.g., corresponding to the controller connection 600 of Figure 6A) and controller connections 600. The array 602 also contains attachment connections, as previously described in reference to Figure 4C. The attachment connections and controller connections may be defined within an array support 650. The array support 650 may be substantially planar. The controller feet 610, orifices 614, and controller connections 620 may be substantially coplanar with the array support 650. In some embodiments, the controller feet 610, the orifices 614, and the controller connections 620 may be recessed with respect to the array support 650 or vice versa. The orifices 614 may be supplied with a variable compressed air signal. The orifices 614 may instead supply another force, such as an electrostatic attractive force, in which case the orifices may instead be contact pads. The controller connections 620 may be supplied with electrical signals, including from voltage sources 622 and 626. The electrical signals may be alternating current (AC), direct current (DC), voltage signals, capacitive signals, inductive signals, etc.

The array 602 is depicted as supporting two die actuators 316, but may instead support more or fewer die actuators. The array 602 may have orifices 614 which operating to control die actuators 316, such as orifices which supply compressed air to attach guides 318 to the die actuator 316 and vacuum force to remove guides 318 from the die actuator 316. The orifices 614 may be individually controlled, such as by supplying an individual control signal to each of the orifices 614. The orifices 614 which do not correspond to (e.g., are not controlling) die actuators 316 may be turned off or otherwise not supplied with a control signal. The array 602 may have voltage sources 622 and 626, which may be individually controlled. The controller connections 620 may have electrical pads which connect to electrical connections in the die actuators 216. The voltage sources 622 and 626 may apply a voltage (or other electrical signal) which may operate electrostatic connections, such as electrostatic die chucks 624. The controller connections 620 which do not correspond to die actuators 316 may be turned off, connected to ground, or otherwise not supplied with a control signal.

The array 602 may have die actuators 316 and donor die (e.g. donor die 310E-D) placed upon it. The die actuators 316 may be supported by a die actuator foot 680A and 680B. The die actuator feet 680A-B may be any appropriate support for the die actuators 316. The die actuators are depicted as containing the expandable bellows 560A and 560B for actuation in the Z-direction, electrostatic die chucks 624, and guide arms 670. The expansion and contraction of the expandable bellows 560A and 560B may be controlled by signals supplied through the controller connections (e.g., the controller connections 500 of Figure 5B). The expandable bellows 560A and 560B are provided as an example, but the actuation of the die actuators 316 may occur via any appropriate method or structure. The die actuators are depicted as containing the electrostatic die chucks 624, which may be controlled by signals supplied by the controller connections 620 to cause adhesion of the donor die 310E and repulsion of the donor die 310D. The electrostatic die chucks 624 are provided as an example of additional die actuation, but the actuation of the die actuators 316 may occur in other manners and via other structures. In some embodiments, the donor die may not be adhered to the die actuators 316. The guide arms 670 are depicted as supporting the guides 318. The guide arms 670 may support all the guides 318 of a die actuator 316. In some embodiments, multiple guide arms 670 may be provided, and may control the guides 318 which prevent motion in different directions using different control signals. The guide arms 670 are depicted as having a pivot point 672 on the die actuator feet 680A and 680B, but this configuration is provided as an example only and the guide arms 670 may operate in any appropriate manner. The guide arms 670 are provided as an example of guide 318 actuation, but the guides may be actuated in any appropriate manner.

An "attraction" signal may be supplied to the electrostatic die chuck 624 via the controller connection 620. The attraction signal may operate to cause the donor die 310E to clamp to the die actuator 316. A "repulsion" signal may be supplied to the electrostatic die chuck 624 via the controller connection 620. The repulsion signal may operate to cause the donor die 310D to detach from the die actuator 316. In some embodiments, a "hold" signal may be supplied via the controller connection 620. The hold signal may operate to cause the die actuator 316 to hold the donor die on the die actuator 316, with or without substantial pressure. In some embodiments, the attraction signal may be absence of the repulsion signal, or vice versa, such as electrostatic die chucks 624 with hysteresis.

A "guide" signal 660 may be supplied via a controller connection to the guide arms 670. The guide signal 660 may operate to cause the guides 318 to clamp to the die actuator 316 to guide placement of the donor die 310E on the target die, to prevent movement of the die actuator 316 in the X-Y plane, etc. The guide signal 660 may cause pivoting of the guide arms 670 towards the die actuator 316.

A "release" signal 662 may be supplied via a controller connection to the guide arms 670. The release signal may operate to cause the guides 318 to release (e.g., withdraw from) the die actuator 316 to allow movement of the die array 602 with respect to the donor die 310D (such as after the donor die 310D is brought into contact with the target die). The release signal 662 may cause pivoting of the guide arms 670 away from the die actuator 316.

In some embodiments, a "hold" signal may be supplied via a controller connection. The hold signal may operate to cause the guide arms 670 to hold the die actuator 316, with or without substantial pressure, but may not cause the guide arms 670 to re-engage with the die actuator if they had been previously released.

In some embodiments, the release signal may be absence of a guide signal, or vice versa, such as for spring loaded die guide arms 670. In some embodiments, a guide signal may automatically include a hold signal or period or other ramping of pressure between guide arms 670, guides 318, and die actuators 316.

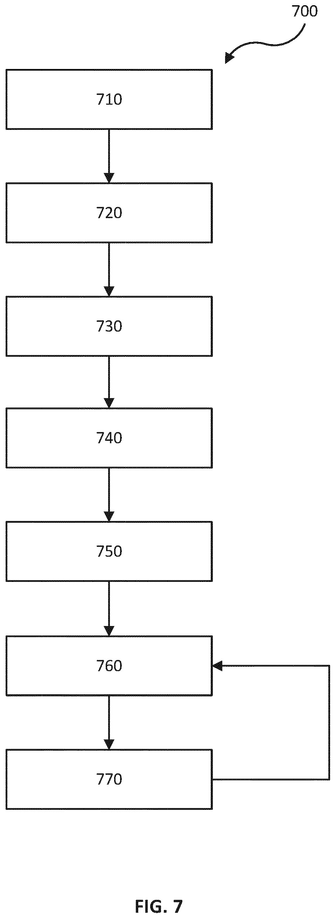

Figure 7 is a flowchart which illustrates a method of die placement. Each of these operations is described in detail below. The operations of method 700 presented below are intended to be illustrative. In some embodiments, method 700 may be accomplished with one or more additional operations not described, and/or without one or more of the operations discussed. Additionally, the order in which the operations of method 700 are illustrated in Figure 7 and described below is not intended to be limiting. In some embodiments, one or more portions of method 700 may be implemented (e.g., by simulation, modeling, etc.) in one or more processing devices (e.g., one or more processors). The one or more processing devices may include one or more devices executing some or all of the operations of method 700 in response to instructions stored electronically on an electronic storage medium. The one or more processing devices may include one or more devices configured through hardware, firmware, and/or software to be specifically designed for execution of one or more of the operations of method 700, for example.

At an operation 710, a plurality of die actuators are placed on an array of connections. The array of connections may include attachment connections and controller connections, as previously described in reference to Figures 4A-4C, 5A-5B, and 6A-6B. The array of connections may be part of an alignment tool, wafer chuck, etc., such as part of the apparatus of Figure 2A-2B. The array of connections may control actuation of the die actuators. The die actuators may be any appropriate die actuators, including those previously described in reference to Figures 2A-2B, 3A-3H, 4A-4C, 5A-5B, and 6A-6B. The die actuators may be placed at any appropriate position on the array of connections. The die actuators may be rotated with respect to the array of connections. The die actuators may include two or more types of die actuators. The die actuators may interact with the array of connections via die actuator feet. The die actuators may be actively attracted to the array of connections. In some embodiments, the die actuators may be passively attracted to the array of connections, such as by gravity. In some embodiments, the die actuators may be oriented such that gravity forces the die actuators away from the array of connections (e.g., upside down), and the active attractive force applied by the array of connections to the die actuators may be large enough to overcome gravity forces.

At an operation 720, a plurality of donor die are placed on the die actuators on the array of connections. The donor dies may be placed on the die actuators by a pick and place tool or any other appropriate method, such as a method of wafer handling compatible with a reconstructed wafer. The donor die placement on the die actuator may be monitored, such as by the pick and place element, such that if the donor die is not placed on the die actuator, the donor die may be re-placed (e.g., repositioned, discarded, etc.). The pitch of the die actuator may be equal to or smaller than the pitch of the donor die. Each die may be placed on one or more die actuators. The recess may have one or multiple recess widths, recess depths, recess lengths, etc. The donor die may be multiple die, such as previously joined die (e.g., two or more stacked die). The plurality of donor dies may include different types of donor die (e.g., die with different patterns fabricated) and die of different sizes.

At an operation 730, a plurality of donor die locations are obtained. The donor die locations may be obtained via measurement of one or more positions of the donor dies along one or more dimension. The locations of the plurality of donor die may be measured with respect to a zero point measurement mark. The locations of the plurality of donor dies may be measured in-plane (e.g., in the x-y plane). The locations of the plurality of donor dies may also be measured via a first method in-plane and measured out of plane (e.g., in the Z direction) via a second method. For example, the locations of the plurality of donor die may be measured based on one or more images in-plane. The locations of the plurality of donor die may be obtained from a two-dimensional image, which may show locations of the edges or corners of the donor die with respect to positions on a support structure or on die actuators. The locations of the plurality of donor die may be obtained based on features (for example electrically active areas) on an exposed surface of the donor die. These features of the donor die may be used as alignment marks or reference marks. In some embodiments, alignment marks may be included as exposed features of the donor die. The alignment marks may be specifically added for die bonding or may be alignment marks corresponding to previous fabrication steps. The plurality of donor die locations may be measured or obtained from storage.

At an operation 740, a plurality of target die locations are obtained. The locations of the plurality of target die may be obtained in any appropriate method, including those described in reference to the operation 730.

At an operation 750, the plurality of donor die and the plurality of target die are brought into proximity. The donor die and the target die may be brought into proximity, such that the donor die are parallel to the target die (e.g., such that a fabrication face of the donor die faces a fabrication face of the target die). The donor die and the target die may be brough into proximity by movement of the plurality of the donor die (such as by movement of a donor wafer chuck) or the target die (such as by movement of a target wafer chuck). The donor die and the target die may be brought together such that donor die and their corresponding target die are separated by a distance which may be traversed by actuation of the die actuator. The donor die and target die may be grossly aligned, such as to within a threshold of gross alignment. The donor die and target die may be held by one or more die actuators.

At an operation 760, the location of a given donor die is adjusted to align with a corresponding target die. A given die of the plurality of dies may be selected. Adjusted includes cases in which locations are minimally or substantially not adjusted after measurement, such as if a measured location corresponds to the target location within a threshold. The location of the donor die may be adjusted by action of die actuators. The location of the donor die may be adjusted by action of a wafer handling apparatus, such as a microstepper. The location of the donor die may be adjusted by movement of the array of connections. The die actuator, wafer handling apparatus, or array of connections may adjust a position of the donor die in one or more direction, such as in the X-Y plane. The die actuator, wafer handling apparatus, or array of connections may adjust a length, position, angle of one or more support (e.g., a strut) which supports a donor die or the array of connections. The die actuators, wafer handling apparatus, or array of connections may be controlled, including electrically controlled, by one or more measurement systems, such as a measurement system which incorporates a location measurement element. The die actuators, wafer handling apparatus, or array of connections may be controlled by a system, such as the one or more measurement systems, which also controls a pick and place element or other element which places the die actuators on the array of connections or the donor die on the die actuators. Adjustment of the locations of the donor die may correspond to adjustment of one or more donor die chuck. Adjustment of the locations of the donor die may correspond to adjustment of locations of one or more donor die actuators. Adjustment of the locations of the donor die may include iterative measurement of the plurality of donor die locations, including as adjustment occurs.

Adjustment of the locations of the donor die locations may occur at a given position of a stage (e.g., a donor wafer chuck), such as at a measurement position. Adjustment of the position of the donor die may occur after the locations of the plurality of donor die are obtained, such as by a location measurement element.

Adjustment of the locations of the donor die may occur based on a target of the donor die. The target may be a target location. A target (e.g., target location) may be obtained. The target may correspond to a location of the target die. The target may correspond to a plurality of locations on the target die. The target may be a position (e.g., a position in three dimensions such as along X, Y, and Z axes, positions in six directions such as along X, Y, and Z axes and with respect to angles of rotation about those axes, etc.). The target may be a set of positions, for example 2 or more positions of or on target die (such as electrically active areas like electrically active areas 108 of Figure 1A) to which areas of the donor die are to be bonded.

The target may be obtained from a target pattern, e.g., from a plan of the targets. The target location may be obtained from measurement, for example from measurement of the target die. The target may be obtained in any appropriate coordinate system, such as relative to one or more zero measurement marks on a target wafer, on die actuators, on a support structure, etc.

In some embodiments, the targets may be used to inform the pick and place element when placing the donor die on the die actuators. In some embodiments the donor die may be placed on the die actuators based on the obtained target location. That is, the target may be used to inform the pick and place element when placing the plurality of donor die.

Adjustment of the locations of the donor die may include adjustment of the donor die to a location corresponding to a target of the donor die, which may not be identical to a location of the target die. That is, a location corresponding to the target may be a location which corresponds to but is not equal to the target location. For example, the location corresponding to the target of the donor die may be a location which are at the limits of adjustment of the donor die, such as a target which lie outside an adjustment range of the donor die (by the die actuator, by the array of connections, etc.). Alternatively, if a target lies outside the extents of donor die adjustment, the donor die may not be placed on the target, such as if it is determined that bonding would not be possible based on the target location. The location corresponding to the target may be an approximation of target location, such as to within a measurement precision. The location corresponding to the target may be an intermediate location (such as during iterative adjustment of the locations of the donor dies), a placement location (such as a location between the location of the donor dies and the target die), etc.

For example, the donor die and the target die may be used to determine placement locations, such as a placement location for each donor die and corresponding target die, to which both the donor die and corresponding target die may be adjusted. A donor die location and a target die location may be obtained (e.g., measured) and a placement location may be determined, where the placement location is a location to which both the donor die and target may be adjusted. For example, if a donor die is offset by 4 µm in first direction (e.g., from an intended position) and a target die is offset by 1 µm in an antiparallel direction, both the donor die and the target die may be adjusted in position to meet at a placement location (where placement of the donor die on the target may occur).

At an operation 770, the given donor die is placed on the one or more target die. The donor die may be placed on the targets by movement of die actuator. The donor die may experience self-alignment as the donor die is brought into contact with the targets. For example, the donor die may be biased with respect to the target locations such that electrically active areas of the donor die are attracted to certain areas, such as electrically attractive areas, of the target locations. The donor die may be adhered to the target die. The donor die may be bonded, such as by annealing, to the target die. The donor die may be held against the target die for a bonding time period. The die actuator may be released in one or more directions, such that as the donor die is held against the target die, the array of connections may move. The donor die may be released from the die actuators or from the array of connections.

In some embodiments, an additional donor die may be placed on the same or different target die. For example, if the targets correspond to targets for a target wafer, the targets acquired for one of the target wafers may be applied to additional target wafers with the same manufacturing parameters. In another example, if multiple die are to be stacked, targets for a second layer stacking may be acquired when the first layer stacking occurs-e.g., donor die locations for a first layer stacking may be used as targets for a second layer stacking.

As described above, method 700 (and/or the other methods and systems described herein) is configured for alignment of multiple die.

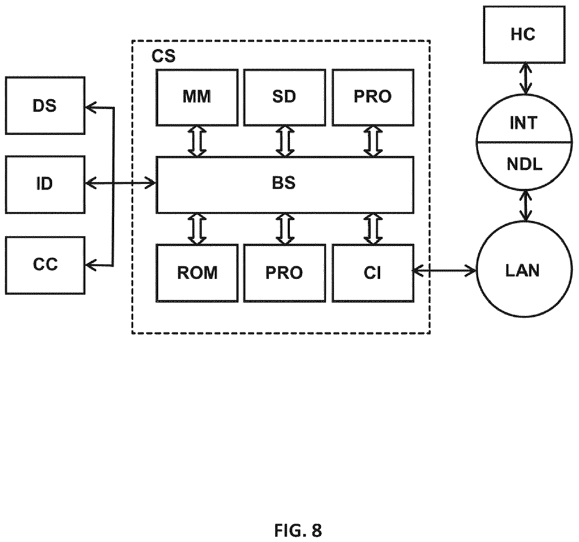

Figure 8 is a diagram of an example computer system CS that may be used for one or more of the operations described herein. Computer system CS includes a bus BS or other communication mechanism for communicating information, and a processor PRO (or multiple processors) coupled with bus BS for processing information. Computer system CS also includes a main memory MM, such as a random-access memory (RAM) or other dynamic storage device, coupled to bus BS for storing information and instructions to be executed by processor PRO. Main memory MM also may be used for storing temporary variables or other intermediate information during execution of instructions by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a cathode ray tube (CRT) or flat panel or touch panel display for displaying information to a computer user. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

In some embodiments, portions of one or more methods described herein may be performed by computer system CS in response to processor PRO executing one or more sequences of one or more instructions contained in main memory MM. Such instructions may be read into main memory MM from another computer-readable medium, such as storage device SD. Execution of the sequences of instructions included in main memory MM causes processor PRO to perform the process steps (operations) described herein. One or more processors in a multi-processing arrangement may also be employed to execute the sequences of instructions contained in main memory MM. In some embodiments, hard-wired circuitry may be used in place of or in combination with software instructions. Thus, the description herein is not limited to any specific combination of hardware circuitry and software.

The term "computer-readable medium" and/or "machine readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or light waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the operations described herein. Transitory computer-readable media can include a carrier wave or other propagating electromagnetic signal, for example.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic, or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) may use electrical, electromagnetic, or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN, and communication interface CI. One such downloaded application may provide all or part of a method described herein, for example. The received code may be executed by processor PRO as it is received, and/or stored in storage device SD, or other non-volatile storage for later execution. In this manner, computer system CS may obtain application code in the form of a carrier wave.

Embodiments include the following numbered clauses:
Clause 1: a support structure for die comprising:
   an array of attachment connections configured to hold die actuators, each of the die actuators held by at least one attachment connection; and
   an array of controller connections configured to interface with die actuators to control movement of the die actuators,
   wherein the array of controller connections is interspersed in the array of attachment connections.
Clause 2: the support structure of clause 1, wherein the support structure further comprises a plurality of die actuators, individual of the die actuators attached to the support structure via at least one of the attachment connections and individual of the die actuators connected to at least one of the controller connections.
Clause 3: the support structure of clause 2, wherein the die actuators are configured to mechanically move dies in a direction substantially perpendicular to a longitudinal plane of the support structure. Clause 4: the support structure of clause 2, wherein the die actuators are individually controllable via the controller connections.
Clause 5: the support structure of clause 2, wherein the die actuators are placed on the support structure and attached to the support structure by activation of the attachment connections.
Clause 6: the support structure of clause 5, wherein the die actuators are detached from the support structure by deactivation of the attachment connections.
Clause 7: the support structure of clause 1, wherein a face of the support structure defines the attachment connections and the controller connections.
Clause 8: the support structure of clause 7, wherein the face is substantially planar.
Clause 9: the support structure of clause 1, wherein the attachment connections are orifices configured to hold individual die actuators by applying vacuum force.
Clause 10: the support structure of clause 1, wherein the attachment connections are electrical connections configured to hold individual die actuators by applying electrostatic force.
Clause 11: the support structure of clause 1, wherein the controller connections comprise at least one of:
   orifices configured to control movement of the die actuators by applying vacuum force,
   orifices configured to control movement of the die actuators by applying compressed air force, and
   electrical connections configured to control movement of the die actuators by applying electrical signal.
Clause 12: the support structure of clause 1, wherein the array of controller connections comprises controller connections of at least two different types.
Clause 13: a system for die positioning comprises at least two support structures of any one of clauses 1-10.
Clause 14: a system for die positioning comprising:
   a first stage supporting an array of die actuators, wherein the die actuators are configured to actuate at least one of a plurality of donor dies;
   a second stage supporting a plurality of target dies; and
   a measurement system functionally coupled to at least one of the first stage and the second stage and configured to:
      obtain a relative position between a first donor die of the plurality of donor dies and a first target die of the plurality of target dies;
      position at least one of the first stage and the second stage such that a position of the first donor die corresponds to a position of the first target die; and
      activate a die actuator supporting the first donor die to place the first donor die on the first target die.
Clause 15: the system of clause 14, wherein the measurement system is further configured to:
   obtain a relative position between a second donor die of the plurality of donor dies and a second target die of the plurality of target dies;
   position at least one of the first stage and the second stage such that a position of the second donor die corresponds to a position of the second target die; and
   activate a die actuator supporting the second donor die to place the second donor die on the second target die.
Clause 16: the system of clause 15, wherein the measurement system is further configured to:
   maintain pressure from the die actuator supporting the first donor die placed on the first target die after placing the first donor die on the first target die; and
   position at least one of the first stage and the second stage such that the position of the second donor die corresponds to a position of the second target die while maintaining pressure supporting the first donor die.
Clause 17: the system of clause 15, wherein the measurement system is configured to obtain the relative position between the first donor die and the first target die and the relative position between the second donor die and the second target die substantially simultaneously.
Clause 18: the system of clause 14, wherein the measurement system is further configured to retract the die actuator supporting the first donor die after a bonding time period has expired.
Clause 19: the system of clause 14, wherein the measurement system is configured to obtain the relative position between the first donor die and the first target die based on a measurement of the position of the first donor die with respect to a reference point on the first stage and a measurement of the position of the first target die with respect to a reference point on the second stage.
Clause 20: the system of clause 14, wherein the measurement system is configured to position at least one of the first stage and the second stage such that the position of the first donor die corresponds to the position of the first target die to within a threshold.
Clause 21: the system of clause 14, wherein the measurement system configured to activate the die actuator comprises a measurement system configured to controllably guide the first donor die into contact with the first target die.
Clause 22: the system of clause 21, wherein the first stage further comprises a plurality of guide rails, each die actuator guided by at least one guide rail.
Clause 23: the system of clause 22, wherein each guide rail guides a position of a corresponding die actuator in a direction substantially perpendicular to a longitudinal plane of the first stage.
Clause 24: the system of clause 22, wherein each guide rail prevents movement of a corresponding die actuator in a direction substantially parallel to a longitudinal plane of the first stage.
Clause 25: the system of clause 22, wherein the at least one guide rail disengages from the die actuator after the first donor die is placed on the first target die.
Clause 26: the system of clause 25, wherein the at least one guide rail reengages with the die actuator after the die actuator is retracted from placing the first donor die on the first target die.
Clause 27: the system of clause 14, wherein the first stage and the second stage are substantially parallel and wherein the die actuator places the first donor die on the first target die along a direction substantially perpendicular to the parallel plane of the first stage and the second stage.
Clause 28: the system of clause 27, wherein the first stage and the second stage are positioned opposite one another about the parallel plane.
Clause 29: the system of clause 27, wherein the first stage is supported by a moveable wafer chuck and wherein the measurement system configured to position at least one of the first stage and the second stage comprises the measurement system to position the moveable wafer chuck.
Clause 30: the system of clause 29, wherein the moveable wafer chuck further comprises a third stage supporting a second array of die actuators and wherein the moveable wafer chuck is further configured to swap positions of the first stage and the third stage.
Clause 31: the system of clause 29, wherein the measurement system configured to obtain a relative position between the first donor die of the plurality of donor dies and the first target die of the plurality of target dies comprises the measurement system configured to measure a position of the first donor die at a first position of the moveable wafer chuck and wherein the measurement system configured to activate the die actuator supporting the first donor die to place the first donor die on the first target die comprises the measurement system configured to activate the die actuator supporting the first donor die to place the first donor die on the first target die at a second position of the moveable wafer chuck.

While the concepts disclosed herein may be used for manufacturing with a substrate such as a silicon wafer, it shall be understood that the disclosed concepts may be used with any type of manufacturing system (e.g., those used for manufacturing on substrates other than silicon wafers).

In addition, the combination and sub-combinations of disclosed elements may comprise separate embodiments. For example, one or more of the operations described above may be included in separate embodiments, or they may be included together in the same embodiment.

The descriptions above are intended to be illustrative, not limiting. Thus, it will be apparent to one skilled in the art that modifications may be made as described without departing from the scope of the claims set out below.

## Claims

1. A support structure for die comprising:
an array of attachment connections configured to hold die actuators, each of the die actuators held by at least one attachment connection; and
an array of controller connections configured to interface with die actuators to control movement of the die actuators,
wherein the array of controller connections is interspersed in the array of attachment connections.

2. The support structure of claim 1, wherein the support structure further comprises a plurality of die actuators, individual of the die actuators attached to the support structure via at least one of the attachment connections and individual of the die actuators connected to at least one of the controller connections.

3. The support structure of claim 2, wherein the die actuators are configured to mechanically move dies in a direction substantially perpendicular to a longitudinal plane of the support structure.

4. The support structure of claim 2, wherein the die actuators are individually controllable via the controller connections.

5. The support structure of claim 2, wherein the die actuators are placed on the support structure and attached to the support structure by activation of the attachment connections.

6. The support structure of claim 5, wherein the die actuators are detached from the support structure by deactivation of the attachment connections.

7. The support structure of claim 1, wherein a face of the support structure defines the attachment connections and the controller connections.

8. The support structure of claim 1, wherein the attachment connections are orifices configured to hold individual die actuators by applying vacuum force, or wherein the attachment connections are electrical connections configured to hold individual die actuators by applying electrostatic force.

9. The support structure of claim 1, wherein the controller connections comprise at least one of:
orifices configured to control movement of the die actuators by applying vacuum force,
orifices configured to control movement of the die actuators by applying compressed air force, and
electrical connections configured to control movement of the die actuators by applying electrical signal.

10. The support structure of claim 1, wherein the array of controller connections comprises controller connections of at least two different types.

11. A system for die positioning comprising:
a first stage supporting an array of die actuators, wherein the die actuators are configured to actuate at least one of a plurality of donor dies;
a second stage supporting a plurality of target dies; and
a measurement system functionally coupled to at least one of the first stage and the second stage and configured to:
obtain a relative position between a first donor die of the plurality of donor dies and a first target die of the plurality of target dies;
position at least one of the first stage and the second stage such that a position of the first donor die corresponds to a position of the first target die; and
activate a die actuator supporting the first donor die to place the first donor die on the first target die.

12. The system of claim 11, wherein the measurement system is further configured to:
obtain a relative position between a second donor die of the plurality of donor dies and a second target die of the plurality of target dies;
position at least one of the first stage and the second stage such that a position of the second donor die corresponds to a position of the second target die; and
activate a die actuator supporting the second donor die to place the second donor die on the second target die.

13. The system of claim 12, wherein the measurement system is further configured to:
maintain pressure from the die actuator supporting the first donor die placed on the first target die after placing the first donor die on the first target die; and
position at least one of the first stage and the second stage such that the position of the second donor die corresponds to a position of the second target die while maintaining pressure supporting the first donor die.

14. The system of claim 12, wherein the measurement system is configured to obtain the relative position between the first donor die and the first target die and the relative position between the second donor die and the second target die substantially simultaneously.

15. The system of claim 11, wherein the measurement system is further configured to retract the die actuator supporting the first donor die after a bonding time period has expired.
